# EUROPEAN PATENT APPLICATION

(11) **EP 1 381 259 A1**
(43) Date of publication of application: **14.01.2004**
(21) Application number: 02254875.4
(22) Date of filing: 11.07.2002
(51) Int. Cl.: H05K 3/24, H05K 3/28

(54) **Structure of printed circuit board (PCB)**

(71) Applicant: Ultratera Corporation, Hsin-Chu (TW)
(72) Inventor: Maa, Chong-Ren, Sungshan Chiu, Taipei (TW); Chih, Wan-Kuo, Judung Jen, Hsinchu (TW); Tsou, Ching-Hua, Yunghe City, Taipei (TW)
(74) Representative: O'Connell, David Christopher

(57) **Abstract**

A printed circuit board comprises a substrate (10) with a conductor pattern (20) thereon. The conductor pattern (20) is composed of a plurality of traces (21) in a specific layout. The conductor pattern (20) has first sections (211) where adapt to let current flowing through and second sections (212) electrically connected with the first sections (211) respectively. The first sections (211) of the conductor pattern (20) have plating portions (213) for providing connecting layers (22) thereon, and a solder mask (30) is provided on the substrate (10). The solder mask (30) shelters the conductor pattern (20) but exposes the connecting layers (22) on the plating portions (213) of the first sections (211) of the conductor pattern (20). The solder mask (30) has apertures (34) at where relate to the second sections (212) of the conductor pattern (20).

## Description

### FIELD OF THE INVENTION

The present invention relates to an electronic product, and more particularly to a structure of a printed circuit board (PCB).

### BACKGROUND OF THE INVENTION

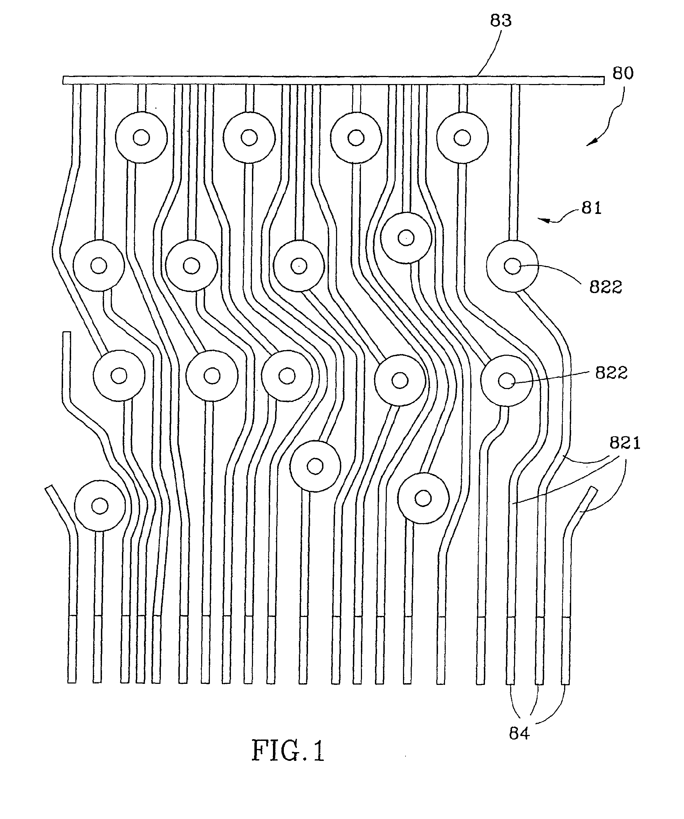

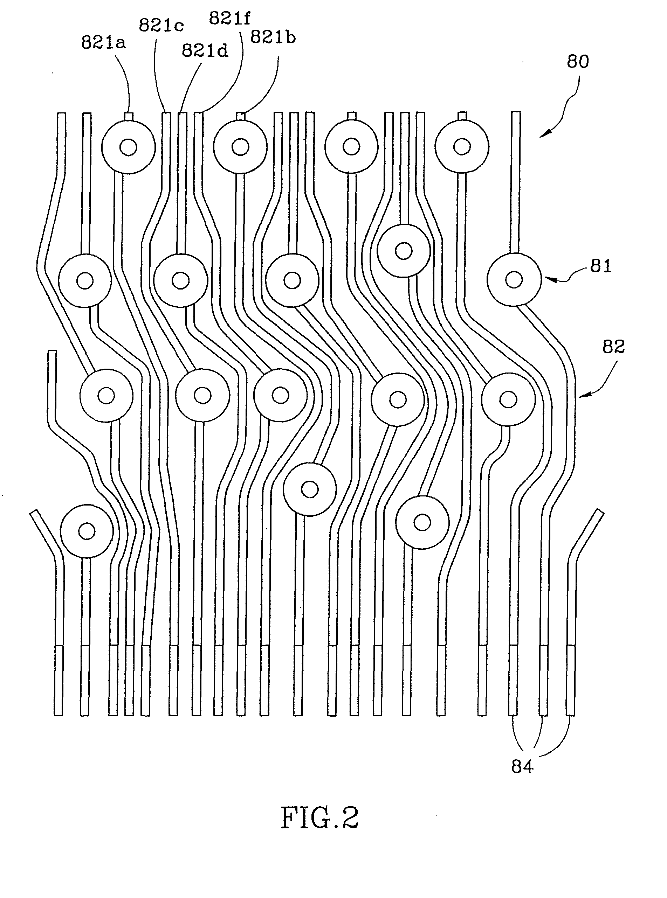

In a conventional method of manufacturing a printed circuit board (PCB) 80, please refer to FIG. 1, first, prepare a substrate 81 with a conductor pattern 82 thereon. The conductor pattern 82 is composed of a plurality of traces 821 in specific layout. Plated through holes (PTHS) 822 are provided to the substrate 81. A bus trace 83 is provided on the substrate 81 electrically connected with the tail ends of the traces 821. Electricity is added to the bus trace 83 to plate connecting layers 84 (the Ni-Au alloy layers) on the conductor pattern 82. Then, the bus trace 83 is removed to form the conductor pattern 82 of the PCB 80 as shown in FIG. 2.

It is obvious to understand that spaces 821 must be left on the substrate 81 between the traces 821a and 821b for invalid sections 821c and 821d, which are the sections of the traces 821 having no current flowing, passing though. In the other words, the conventional substrate 81 has a larger invalid space thereon and can not be eliminated.

### SUMMARY OF THE INVENTION

The primary objective of the present invention is to provide a printed circuit board, which can be designed in a smaller size.

According to the objective of the present invention, a printed circuit board comprises a substrate with a conductor pattern thereon and a solder mask. The conductor pattern has first sections where adapt to let current flowing through and second sections electrically connected with the first sections respectively. The first sections of the conductor pattern have plating portions for plating connecting layers thereon. The solder mask is provided on the substrate. The solder mask shelters the conductor pattern but exposes the connecting layers on the plating portions of the first sections of the conductor pattern. The solder mask has apertures at where relates to the second sections of the conductor pattern.

### BRIEF DESCRIPTION OF THE DRAWINGS

FIG. 1 is a perspective view of a conventional PCB, showing a bus trace provided on the substrate to plate connecting layers on the conductor pattern;
FIG. 2 is a perspective view of the conventional PCB, showing the bus trace being removed;
FIG. 3 is a perspective view of a prefer embodiment of the present invention;
FIG. 4 is a sectional view of the prefer embodiment of the present invention;
FIG. 5 is a perspective view of a copper trace of conductor pattern, showing the aperture located beside a plated through hole;
FIG. 6 is a perspective view of a copper trace of conductor pattern, showing the aperture located beside a solder ball pad;
FIG. 7 is a perspective view of the PCB of the prefer embodiment of the present invention, and
FIG. 8 is a perspective view of another PCB of the prefer embodiment of the present invention.

### DETAIL DESCRIPTION OF THE INVENTION

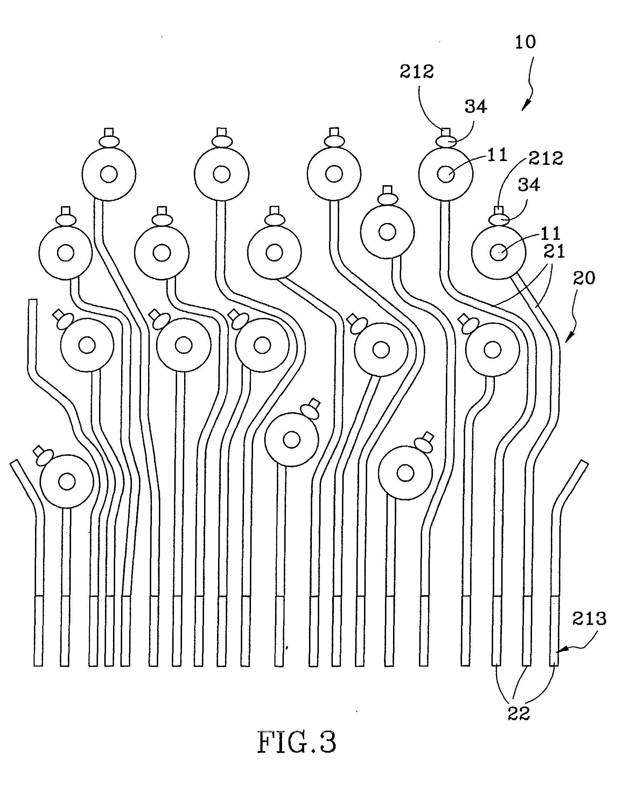

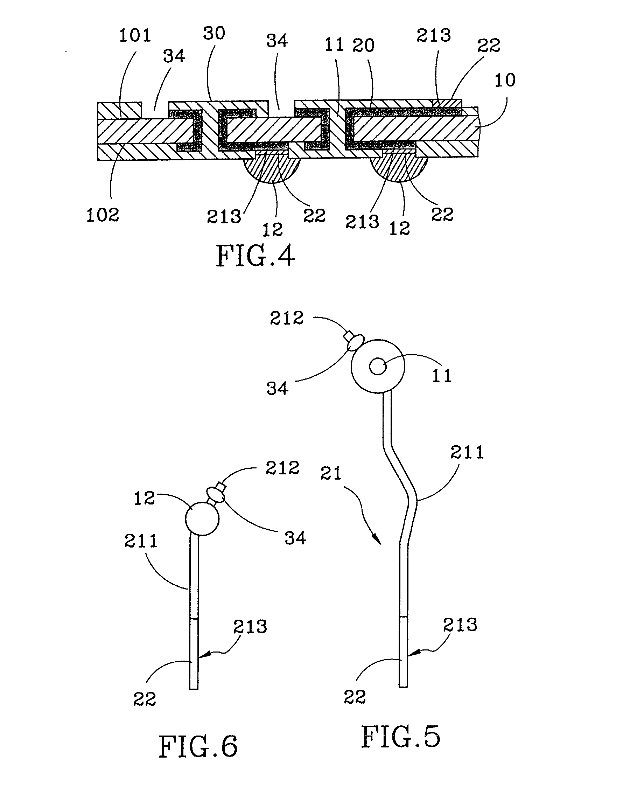

Please refer to FIG. 3 and FIG. 4, a printed circuit board (PCB) of a prefer embodiment of the present invention comprises:

A substrate 10 is made of multi-function epoxy resin having a first side 101 and a second side 102. The substrate 10 is drilled a plurality of through holes 11 at specific positions from the first side 101 to the second side 102.

A conductor pattern 20 is composed of a plurality of copper traces 21 in a specific layout provided at both of the first side 101 and the second side 102 of the substrate 10. The through holes 11 are provided with the copper foils on the side walls to electrically connect the copper traces 21 at the first side 101 and the second side 102 of the substrate 10 so that they will be plated through holes (PTH). The copper traces 21 close to each other as possible to make the conductor pattern 20 has a smaller size.

Please refer to FIG. 5, the conductor pattern 20 are defined to first sections 211 and second sections 212.

The first sections 211 are the copper traces 21 of the conductor pattern 20 where adapt to let current flowing through, so that the PTHS 11 and the solder ball pads 12 are located at the first sections 211. The first section 211 of the conductor pattern 20 has plating portions 213 to plate connecting layers 22 thereon. The connecting layers 22 are usually made from plating Ni-Au alloy on the plating portions 213 respectively, which are to provide solder ball pads 12 thereon or to bond wires (not shown) or to conduct the conductor pattern 20 to another circuit (not shown).

The second sections 212 are the shorter copper traces beside the first sections 211 and are electrically connected with the first sections 211. They usually are located at where close to the ends of the copper traces 21 where has no current flowing through. In other words, the second sections 212 are the invalid sections of the conductor pattern 20. The second sections 212 can be located at where beside the PTH 11 as shown in FIG. 5 or beside a solder ball pad 12 as shown in FIG. 6 or at the other sections of the conductor pattern 20 having no current flowing through.

A solder mask 30 is coated on the first side 201 and the second side 202 of the substrate 10 and fills the PTHS 11. The solder mask 30 can be made of masking material such as multi-function epoxy resin. The solder mask 30 shelters the conductor pattern 20 but exposes the connecting layers 214. The solder mask 30 has apertures 34 at where relates to the second sections 212 of the conductor pattern 20 and the second sections 212 of the conductor pattern 20 are removed at where under the apertures 34 of the solder mask 30.

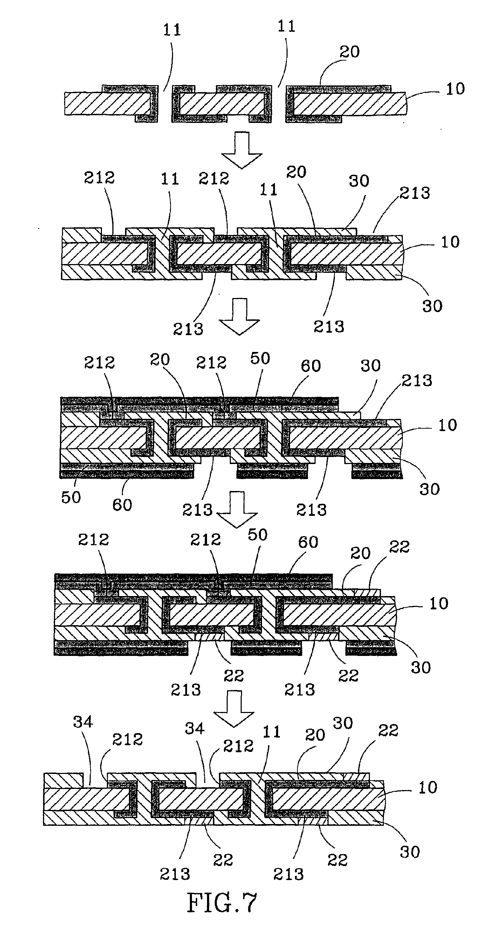

Please refer to FIG. 7, hereunder we will disclose a process to manufacture the PCB of the present invention to teach why the solder mask 30 having the apertures 34 relating to the second sections 212 of the conductor pattern 20 will make the conductor pattern having a smaller size.

First, referring to FIG. 7A, prepare the substrate 10 with the conductor pattern 20 thereon.

Second, coat the solder mask 30 on the substrate 10 sheltering the conductor pattern 20 and remove the unnecessary parts thereof at where relate to the plating portions 213 of the conductor pattern 20 and the apertures 34 as shown in FIG. 7B.

Third, referring to FIG. 7C, plate a conductive layer 50 onto the solder mask 30 and then coat a masking layer 60 onto the conductive layer 50. the unnecessary parts of the conductive layer 50 and the masking layer 60 at where relate to the plating portions 213 of the conductor pattern 20. The conductive layer 50 now is electrically connected with the conductor pattern 20 via the second sections 212 and the plating portions 213 are exposed.

Fourth, referring to FIG. 7D, add electricity to the conductive layer 50 to plate the connecting layers 214 on the plating portions 213 of the conductor pattern 20.

Finally, remove the masking layer 60 and the conductive layer 50. It is clear to see that the apertures 34 are left on the solder mask 30 and the second sections 212 under the apertures 34 are removed too in the last procedure as shown in FIG. 7E.

You can find that there is no bus trace provided in the processes disclosed above. So, the copper traces of conductor pattern can close to each other as possible without having to remain the space for the bus trace and the invalid segments of the copper traces. The substrate and the conductor pattern can be reduced the sizes thereof.

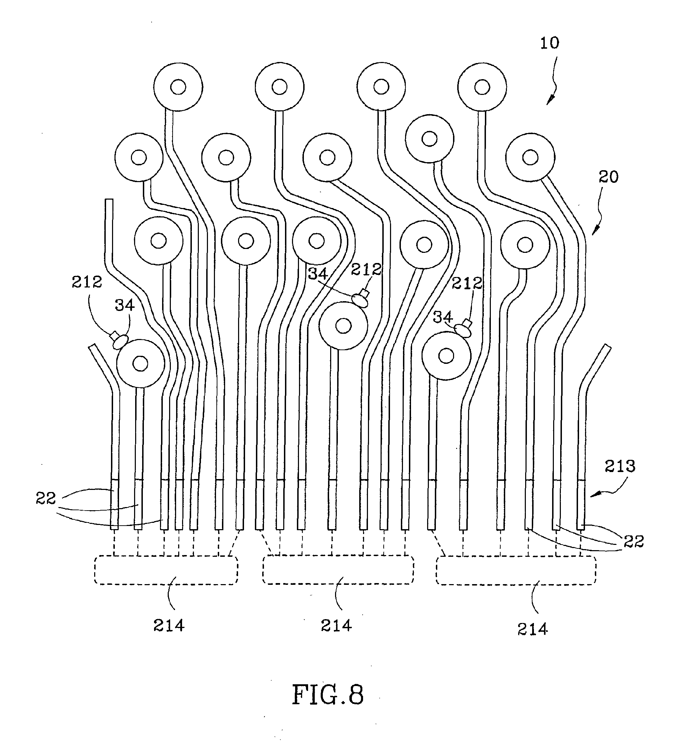

Please refer to FIG. 8, the conductor pattern 20 further has conducting portions 214 to electrically connected with the first sections 211 so that only one or two second sections 212 are provided in the traces 21 connected by the conducting portion 214. In other words, there is no need to form the apertures 34 on the solder mask 30 relating to each trace 21. The conducting portions 214 will be removed, so I show the conducting portions 214 as the dot line in FIG. 8.

## Claims

1. A printed circuit board, comprising:
a substrate;
a conductor pattern composed of a plurality of traces in a specific layout provided on said substrate;
said conductor pattern comprising at least a first section and at least a second section, wherein said first section adapts to let current flowing through having at least a plating portion for providing a connecting layer thereon and said second section is electrically connected with at least one of said plating portion via said first section;
a solder mask provided on said substrate; said solder mask sheltering said conductor pattern but exposing said connecting layer on said plating portion of said first section of said conductor pattern;
said solder mask having aperture at where relate to said second section of said conductor pattern.

2. The printed circuit board as define in claim 1, wherein said substrate has at least a plated through holes located at said first section of said conductor pattern and said aperture of said solder mask is located at where beside said plated through hole.

3. The printed circuit board as define in claim 1, wherein said connecting layer is provided with a solder ball pad thereon and said aperture of said solder mask is located at where beside said solder ball pad.

4. The printed circuit board as define in claim 1, wherein said aperture of said solder mask is located at where close to the ends of said traces of said conductor pattern.

5. The printed circuit board as define in claim 1, wherein said aperture of said solder mask is located at where beside said connecting layer.

6. The printed circuit board as define in claim 1, wherein said second section of said conductor pattern is removed at where under said aperture of said solder mask.
